(19) Europäisches Patentamt / European Patent Office / Office européen des brevets

(11) **EP 2 660 655 B1**

## (12) EUROPEAN PATENT SPECIFICATION

(45) Date of publication and mention
of the grant of the patent:
**01.04.2020   Bulletin 2020/14**

(51) Int Cl.:
*G03F 7/20* (2006.01)        *H01L 21/67* (2006.01)
*H01J 37/317* (2006.01)     *H01J 37/20* (2006.01)
*H01L 21/687* (2006.01)

(21) Application number: **13179130.3**

(22) Date of filing: **11.07.2008**

(54) **Lithography system, method of clamping and wafer table**

Lithographiesystem, Klemmverfahren und Wafertisch

Système de lithographie, méthode de fixation, et table support de tranches

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **13.07.2007   US 959531 P
13.07.2007   NL 1034131**

(43) Date of publication of application:
**06.11.2013   Bulletin 2013/45**

(62) Document number(s) of the earlier application(s) in
accordance with Art. 76 EPC:
**08779017.6 / 2 179 327**

(73) Proprietor: **ASML Netherlands B.V.
5504 DR Veldhoven (NL)**

(72) Inventors:
• **Kruit, Pieter
2628 XK Delft (NL)**

• **De Boer, Guido
2628 XK Delft (NL)**
• **Dansberg, Michel
2628 XK Delft (NL)**

(74) Representative: **Peters, John Antoine et al
ASML Netherlands BV
Corporate Intellectual Property
De Run 6501
P.O. Box 324
5500 AH Veldhoven (NL)**

(56) References cited:
**EP-A- 1 304 727        EP-A- 1 791 027
EP-A- 1 923 743        JP-A- 2006 310 588
US-A1- 2005 122 503    US-A1- 2005 259 236
US-A1- 2006 017 893**

**Description**

FIELD OF THE INVENTION

The present invention relates to a lithography system for projecting an image pattern on to a target surface such as a wafer, and to a wafer table.

Such systems are generally known, e.g. from WO 2004038509. In the example presented by the latter system, the target to be patterned is subjected to incidence of photons or charged particles such as ions and electrons. So as to realize high precision patterning of the target, it is to be firmly bonded or connected to a target table by means of which the target is moved relative to the source of incidence, at least if position measurement of said target is performed via said target table. Such movement is performed at least in a direction essentially transversely tot a main direction of incidence. It is preferably also to remain in position relative to said table during handling of the target, e.g. during insertion and removal of the target to and from the position where it is to be processed, all be it that relative position of target and table could be measured as a final handling part. Moreover, such requirement should remain valid where insertion and removal is to be performed to and from vacuum environment. Various solutions exist for meeting the above requirements, e.g. by means of electromechanical clamping.

The position where the target, commonly a wafer, is processed in a modern lithography system is a target carrying means, commonly a chuck or a wafer table, here alternatively denoted as a reference to the target. Such reference, i.e. carrying means is shaped ultimately flat so as to support minimization of positioning and/or focus errors during lithographic exposure of the target. To this end, in particular for taking away and/or preventing occurrence of bow and warp therein, the target is at least during exposure maintained in close contact to the reference by the exertion of a force thereon. In this manner the target is also maintained optimally within focus depth of the lithography system in which it is included. Commonly said force is realized as a pulling force, generated by electrostatic and or vacuum means acting on said target.

Such solutions however, may have the disadvantage of carrying tubes, cables and/or wiring with the table, thereby increasing the complexity of a required, highly refined positioning of said table relative to a projection means of the litho system. The disadvantage is also present in systems where the target is to be taken out and in integrally with the target table give the coupling and decoupling actions which are then to be performed on cabling, wiring and/or conduits.

Still further and important requirements to lithography system for patterning a target include the realization of flatness thereof, i.e. a requirement towards cancellation of wafer bow and warp, which is done by pulling the target to a reference. The means for performing this function are normally the same as or limited to those for performing the function of keeping the target in position on said table within an exposure field.

The means for maintaining said target in position and/or for pulling the same to a flat reference may be loaded by thermal expansion and contraction due to an energy load of a projection system of the system, as included for patterning said wafer.

Thus a further requirement to the known lithography systems is to realize a thermal conduction between target and target table, in practice so as to conduct heat from said target towards a heat dissipating part of the system. Such swift conduction and dissipation of heat limits positioning distortion by thermal expansion or contraction of the target. The latter is in particular important in modern lithography systems where is a quest for realizing high throughput, e.g. in terms of wafers per hour, the target is subjected to relatively high energy loads which normally translate into heat and which may cause said positioning distortion if not addressed.

Where heat dissipation may be addressed by heat dissipating means, the transport of heat induced to said target towards said heat dissipating means may still be a limiting factor in any solution towards heat dissipation. It is therefore a further object of the present invention to realize a method for clamping and a clamping means which optimally addresses the issue of heat conduction while remaining practical in use and while minimally if not totally not distorting a positioning function of the table or chuck carrying said target.

BACKGROUND

In general positioning of targets such as wafers on a chuck is known from machining processes, as in EP 0100648, JP7237066 and JP8064662, where wafers are frozen on to a chuck before machining the same. According to abstract of the latter publication, a wafer is mounted to a wafer mounting face through a pure water layer having micro thickness. A disadvantage in respect of the required positioning precision in case of transfer of these known concepts to a lithography system, is the piping required for feeding refrigerant through the chuck.

The preceding disadvantage is illustrated in WO 02/21579, which discloses a wafer clamp in a lithography system. The clamp is also used for transport of heat induced by a charged particle beam on a target. The clamping and releasing of the target is in this device performed by applying "one or more" phase transitions to a clamping component that is applied between a wafer and a supporting structure. These phase transitions "facilitate various operations throughout the process" and "ensure that the wafer may be easily loaded and released from the structure. The clamping component is applied in a liquid or gaseous form, and brought into a solid state by active cooling of the support structure, so as to achieve a solid clamping of wafer to said structure. It is here concluded that such a manner of clamping can basically be denoted as gluing the wafer.

The above known clamping device for a lithography system is indicated to be "particularly useful in processes that require wafer cooling", in particular in vacuum due to a large contact area between component and wafer, and a high thermal conductivity of the clamping component. A disadvantage of this known system however, in addition to the required temperature changes in the support structure, is the plurality of conduits required for separately delivering the clamping component and a circulated chilled fluid to the target table.

US patent publication 2005/0186517 relates to a process for a lithography system, of attaching a wafer to a chuck aligning a wafer to a wafer stage and subsequently exposing the wafer. In particular it teaches to cause opposite stress against wafer expansion after an initial stress relieving expansion of a wafer chuck, thereby potentially doubling the amount of allowed heating of the wafer before undesired slip between wafer and chuck occurs. The attaching process is exemplified by a process using electrostatic clamping and by a process of using vacuum clamping, also requiring cabling and or conduits to a moveable table carrying said target.

Outside the vacuum environment encountered in the field of lithographic exposure of targets, it is from the technical area of wafer testing, known by EP patent application 511928 of 1991 en by presentation publication "Liquid interface at wafer test" presented at the SWTW 2005 conference on june 4, 2005, known to integrate heat conduction and clamping of a wafer to a chuck by means of a flowing film of water. The principle conceived in this known device is to realise conduction of target induced heat through the film of water by maintaining the same at ultimately small thickness, however sufficiently large for levelling out roughness as typically encountered at wafer back-sides. Clamping is in this principle according to the first document realised by fluid transfer on the top side of a grooved, planar clamping section of a chuck.

The later document, where the grooves seem to have been omitted form the clamping section, implicitly confirms this explanation by noting that heat is not carried away by fluid flow: "it is conducted through the fluid into the chuck". Moreover it indicates that a wafer is tightly pulled onto the film by means of a vacuum, which vacuum is applied to a liquid film between chuck and wafer, at recovery locations in the chuck, peripheral to a wafer positioned on the chuck, the fluid thereby entering via a central opening.

It is impractical to carry over this concept known from the field of wafer testing to the field of wafer exposure, due to the vacuum circumstances at which lithographic exposure is performed in modern systems. However also for lithographic systems not performing under severe vacuum conditions, a disadvantage exists in that said flowing of water may be an undesired phenomenon in general, and in particular due to a risk of water leads becoming clogged by contaminations. In case of a required vacuum operation the known system fails due to a lack of over pressure at the top side of the target. Where the recovery openings require some amount of vacuum, or pressure below atmospheric for creating the flow of liquid, the central supply opening for the fluid pre-supposes a pressure higher than that at the recovery side. Should this system be entered into a vacuum environment, the target will tend to be lifted from its position rather than that it will tend to be clamped.

SUMMARY OF THE INVENTION

The present invention now, seeks to realise a clamping system for contemporary lithography systems, i.e. with highly refined pixel resolutions and highly refined accurately at relative positioning of target and source. Constraints herewith encompass a vacuum operable system and optimal heat conduction from an exposed target to a target carrying means or chuck. In realising such, the invention proposes to use a stationary liquid film, capillary included between said carrying means and said target for performing both said heat conduction function and a clamping function by the same liquid means. With the novel solution cables or conduits and the like leading from "fixed" world to a moveable target carrying means are entirely obviated, thereby considerably if not totally reducing negative effect thereof on positioning accuracy of the carrying means.

The present invention surprisingly departs from an idea that strong pulling forces may be exerted to liquids like water if the conditions thereto are set properly, as is in very general wording set out in the article "The Physics of negative pressure", published by Discover on march 27, 2003. It was conceived that in the case of lithography systems, such settings could be reached if a liquid was maintained stationary in capillary manner between the surfaces of a target of wafer and a target carrying means or chuck, which surfaces are for obvious reasons normally maintained as flat as possible.

Such conception may in accordance with the present invention be attained utilizing a wafer support in the form of a wafer table as defined by claim 1.

It is remarked in this respect that earlier publications fail to hint at the invention as claimed, in that none of the closest prior at publications relates to a wafer table adapted for realizing a clamp between wafer and wafer table by adaptation of the latter for the use of a stationary layer of liquid between table and wafer for realizing a capillary clamp in an otherwise fully freely moveable and displaceable wafer table. In this respect, US2005/0122503 relates to a support for supporting a substantially flat article to be placed in a beam path of a beam of radiation. This known support is adapted for allowing a back fill gas to be fed between support and article for providing an improved thermal conduction. JP2006310588 relates to substrate device adapted to suppress infiltration of liquid to the rear surface side of the substrate. It is thereto provided with an air supply opening for supplying air to a space surrounded by a first and second support part and the rear surface of the substrate and provided with a exhaust for exhausting air from said space. European patent publication EP1304727 discloses a method comprising placing the wafer on supports within an alignment load-lock. Next, a step of observing the location and orientation of the wafer on the supports within the alignment load-lock is performed. Also performed is a step of moving a chuck so as to align the wafer with respect to the chuck. Once aligned, the chuck is then placed in contact with, and secured to, the wafer, the chuck preferably being embodied as an electrostatic clamping means.

It may be evident that the presently invented principle may be set into practice in various manners.

BRIEF DESCRIPTION OF THE DRAWINGS

The invention will be further elucidated by way of example in the following embodiment of a mask-less lithography system according to the current invention, in which:

Figure 1 in sectional view schematically illustrates a liquid, capillary included between two plate like structures, i.e. surfaces of materials A and B;
Figure 2 is a graphical illustration of the relation of capillary pressure drop for a fused silica optical flat and a silicon wafer, with gap height between such plates capillary including water;
Figure 3 and 4, are schematic illustrations of implementations of the idea underlying the present invention;
Figure 5 is a schematic illustration of a first manner of introducing liquid in the capillary gap between table and target;
Figure 6 by the provision of a circumferential gutter schematically illustrates a measure for minimising evaporation of liquid from the capillary gap;
Figure 7 is a figurative illustration of a manner of realising a liquid layer between target and target table;
Figure 8 is a process flow for a lithographic system, at least part thereof according to the present invention; and
Figure 9 is a schematic illustration of the use of spacers.

In the figures, corresponding structural features, i.e. at least functionally, are referred to by identical reference numbers.

DETAILED DESCRIPTION OF THE INVENTION

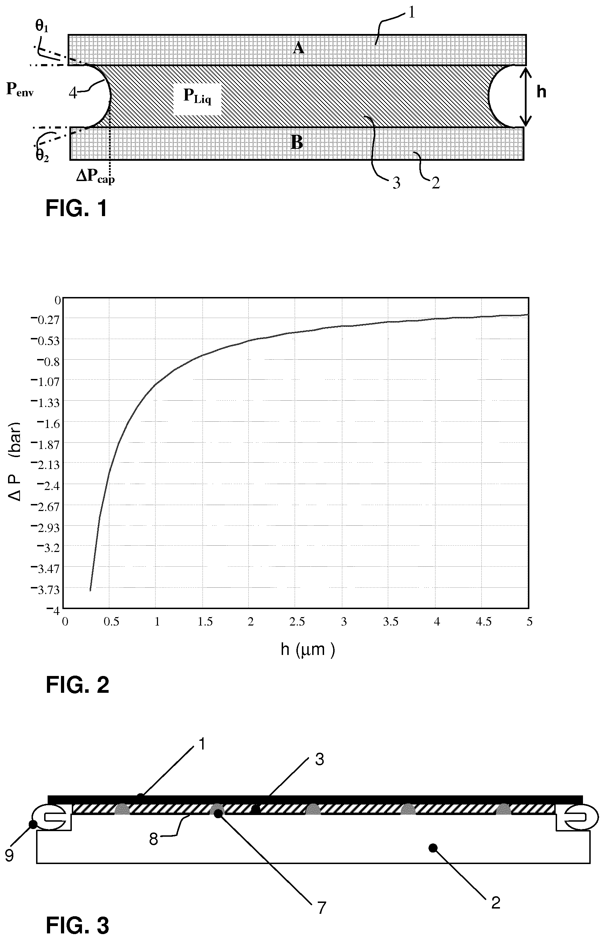

Figure 1 shows a lithography target, here in the form of a wafer 1, which normally moves relative to e.g. a charged particle beam column of a litho apparatus, or other kind of beam source for lithography, by means of an actuated target table or chuck, not indicated in this drawing. Between a top side 8 of such target table 2 and said target 1, a volume of liquid 3 in included capillary. To this end the target 1 and top surface 8 have a mutual nominal distance of gap height h. The volume of liquid, according to the invention preferably water, is such that the radius of the target, as taken in top view, is virtually met by a radius R of the capillary included liquid 3. In any case, the radius of an incircle of the target is at least met by the radius of an excircle fitting the volume of liquid within the boundary of the target. In fact, the liquid is to remain, preferably only with a small distance thereto, within the boundaries of the target. The thus included liquid 3 forms a liquid surface 4, alternatively denoted fluid interface 4 at it's outer periphery which, as taken in the section according to figure 1, is generally concavely shaped, due to adhesive connection of the liquid to the target 1 and the top side 2 of a target table respectively. This concave surface 4 tends to maintain its shape at pulling the target and target table apart, and depends on pressure differential. The concaveness of the interface 4 depends on respective contact angles $\theta_1$ and $\theta_2$, which in turn depend on the material of table 2, and target 1, in this case material A and material B respectively.

In figure 1, the capillary pressure $\Delta P_{cap}$ is the pressure drop over the fluid interface 4 at the edge of the volume of liquid 3. The capillary pressure may according to yet further insight underlying the invention defined by a simplified equation:

$$(1) \qquad \Delta P_{capillary} = \frac{-\gamma_{liquid}\left(\cos\left(\theta_1\right) + \cos\left(\theta_2\right)\right)}{h}$$

In which $\gamma_{liquid}$ is the surface tension of the liquid in [N/m] and in which the contact angles $\theta_1$ and $\theta_2$ are the angles at which the liquid/vapor interface 4 meets the materials A and B respectively. The contact angle is amongst others, however significantly if not predominantly determined by material properties of the liquid 3 and the solid material A and B at the location of interface 4. In the same respect also the following equations holds:

$$P_{env} + \Delta P_{cap} = P_{liq}$$
$$(2)$$

With

$P_{env}$ = environmental pressure
$\Delta P_{cap}$ = capillary pressure at interface 4
$P_{liquid}$ = pressure in liquid 3

Combining equations (1) and (2) it may be seen that
If

$$-\Delta P_{cap} > P_{env}, \; than \quad P_{liquid} < 0 \; bar$$
$$(3)$$

The latter situation arises when $P_{env}$ approximates 0 bar, or under atmospheric pressure when $|\Delta P_{cap}| \geq 1$ bar. Because $P_{liq} < 0$ bar this means that the pressure inside the liquid is negative. It is further recognised that in case $P_{liq}$ is smaller then the vapor pressure of the liquid, then fluid 3 might start to boil or cavitate. Boiling of fluid 3 is however prevented by making the height of the gap smaller then a critical radius of the bubbles.

Figure 2 illustrates the capillary pressure drop, which is taken as indicative for an amount of force that can be exerted, at pulling apart the plates having included a fluid, in casu water, as described above. The depicted curve is derived from a calculation involving two plates, i.e. contacting faces and water, one being a silicon wafer, and the other a fused silica optical flat. The validity of the curve has been tested on the basis of calculations and measurements involving glass plates instead of Si02. The present curve, which compares to that of glass and water, indicates that sufficient pulling power can be developed at gap heights as of nominally 10 $\mu$m and below, which, even at nominal heights of 5 $\mu$m is well in reach of regular lithographic applications. A particularly interesting range exists below a gap height of around 1 $\mu$m and below, since at this gap height the pressure drop is more than 1 bar, implying that negative pressure in the gap liquid already occurs at atmospheric pressure. However, already the pressure drop of near 0,2 bar, occurring at gap height of 10 $\mu$m is sufficient for such clamping that safe handling of a wafer table with placed wafer, e.g. at insertion into vacuum, is guaranteed.

Figure 3 schematically shows part of a lithographic system, including a target 1 embodied by a wafer, a top side 8 of a wafer table 2 or chuck part, a liquid 3 in the form of water, and so called viton or rubber O-rings 9. The O-rings 9 seal off liquid vapour evaporating from the gap containing liquid 3 by being inserted in a rim part of reduced height of the wafer table 2. By this measure the top side of the O-ring is set to a level corresponding in height to that of, and preferably being slightly higher than that of burls 7 on the top side of wafer table 2. Being provided with an incision at a radial side, in this example the radial inward turned side, the O-ring may be compressed between table and wafer without undue force requirement, however sufficient for preventing leakage of vapour, which is especially an issue in the vacuum environment in which such lithography means may be applied. In fact the O-ring, which is here of a thickness in the range from 0 to 5 mm diameter, thus form a C-ring, implying that the pressure required for compressing the O-ring is kept minimal. Some radial distance is kept between the O-ring and the central, raised table part of the target carrying means 2, so as to allow for openings, not depicted here, such as recovery openings for the fluid 3 applied in between. Preferably an 0-ring or kind-like elastically deformable means is applied circumferentially around the target. In this manner larger forces may be applied between target and elastically deformable means, which allows the use of elastically deformable means with higher roughness, which is easier to get hands on, and relatively economic at purchase.

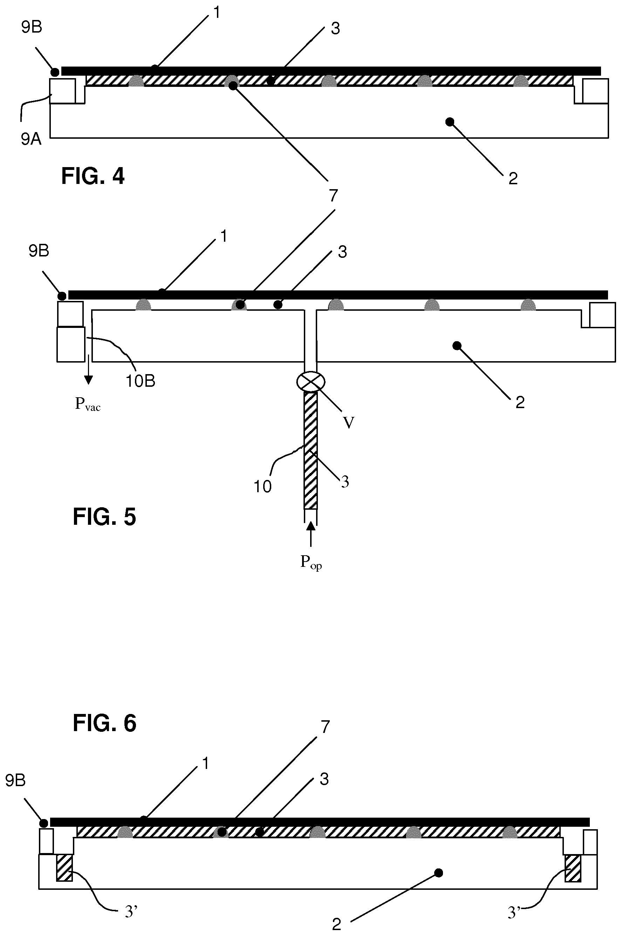

According to the invention, as in figure 4, leakage of vapour is prevented by a vapour limiting ring 9A, supported by an outer rim of the table, largely closing off the circumferential opening of the liquid gap, by leaving a very small vertical distance 9B between ring 9A, and target 1, supported by the burls 7 of the table. In particular this may be 10 to 20 times smaller than the gap height between target and target table.

Further to the set up according to the present invention, use is made of the principle that liquid at a pressure below its vapour pressure is or can be in a metastable state. Notice is taken that there is a critical radius for cavities beyond which such cavities grow unlimited. When now the smallest dimension of the liquid containing volume, as in accordance with preferred embodiment of the invention, is made very small in relative to, or even smaller then this critical radius, cavitation will not occur. When the pressure drop is from the Laplace-pressure, the critical radius is approximately twice the gap height or more. The height depends on the material properties between liquid and solid surface (contact angle).

The invention may further encompass the presence of one or more openings that can be closed for entry of fluid, which may be gas, and opened for release of fluid in said wafer table, thereby enabling release of a target from the table. A volumetrically highly precise fluid entry tube is provided preferably centrally. The invention may also include a pressing means for initially pressing the target into firm contact with said target table, i.e. with a multiplicity of burls 7 thereon. One embodiment for such pressing means involves a high pressure directed perpendicular towards the top side of the target 1, thereby eliminating any bow of the target and allowing the capillary action to be installed. One favourable manner of realising such pressure in accordance with a further aspect of the present invention is to direct a stream of fluidal means such as wind and water on to said target.

Figure 5 illustrates a preferred manner of operation in which initial clamping alternatively denoted chucking, i.e. removing bow in the target is removed and in which liquid is introduced between target and table in a more or less combined manner. To this end a central entry channel 10 is provided in said target table, provided with a valve V. The wafer is chucked to the wafer table by a vacuum force generated by a vacuum pressure $P_{vac}$, applied via a plurality of circumferentially present openings 10B. When the wafer is correctly chucked to the wafer table the valve V is opened and the liquid will be sucked into the gap between the wafer and the wafer table. The filling speed of the water that flows into the gap is determined by the sum of the capillary pressure $\Delta P_{cap}$ and the pressure difference between the prevailing vacuum pressure $P_{vac}$ and an overpressure $P_{op.}$ and present or applied at the entry of channel 10, i.e. at a non-illustrated fluid source. Overpressure $P_{op.}$ is defined to be higher than the pressure $P_{env}$ prevailing over the target. It is for practical reasons limited to 1 bar, so as not to disturb the position of the target on the table, and the effective liquid pressure $P_{liq}$ is calculated with.

Figure 6 illustrates a manner of preventing, at least further minimising evaporation of liquid from the capillary gap, i.e. from between target and target table. Circumferentially to the target, in the target table, and within the area sealed by elastic deformable means 9, or minimal gap 9B, a gutter of significantly larger width than the capillary gap height is made for containing non capillary included liquid 3'. Preferably the fluid 3' is of the same type as the capillary included fluid 3. It is however provided with a significantly larger surface or interface area. Although this gutter could be filled using the liquid source with pressure $P_{op.}$ for channel 10, be it via a separate lead and valve, preferably separate filling means are provided, i.e. independent from the supply of capillary included fluid. The filling means may be any independent filling means, e.g. including a separate liquid source, dedicated leads and valve towards said gutter, and/or a fluid pump.

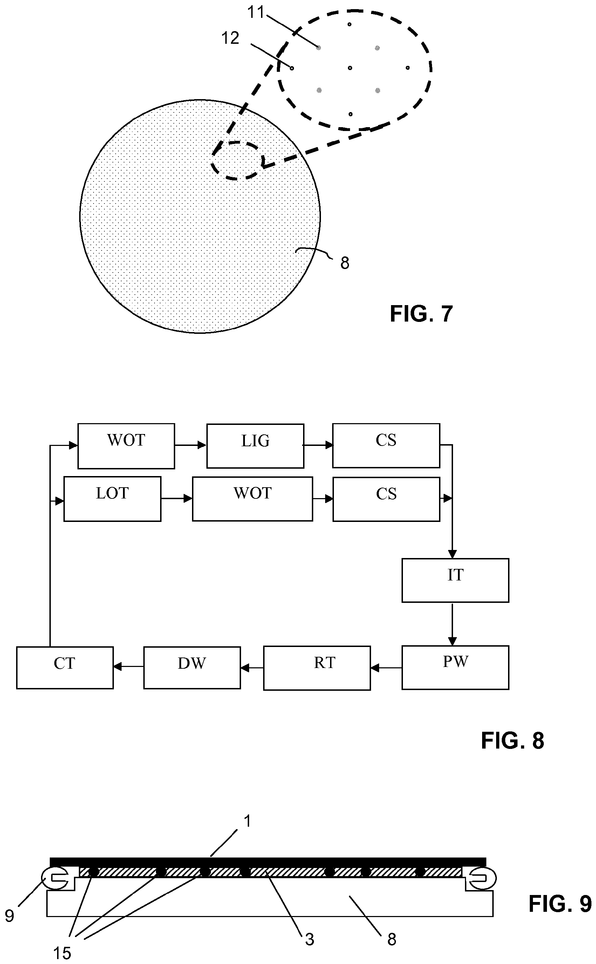

Figure 7 figuratively illustrates an alternative manner of introducing said capillary layer. Rather than entering fluid via a central opening as in the first embodiment example, the fluid is here entered to either one or both surfaces of table and target by depositing droplets 11, e.g. by spraying. Preferably however the deposition in a controlled manner so as to achieve evenly distributed liquid parts, e.g. by placing droplets by means of a droplet dispensing means, for example having one or more droplet dispensing mouths at predefined locations. In these manners of deposition a swift distribution of liquid is achieved, enhancing the practicability of the present new clamping method and means therefore. In the present example droplets are deposited on the target table 2. In this embodiment various openings 12 for prevention of air inclusion are distributed in a pre-defined manner, preferably generally evenly distributed, over the area of the target table.

Apart from above said openings, the surface of the target table is defined by the presence of burls 7, which burls are for the sake of withstanding the clamping force of the capillary liquid included with an increased density of distribution. In this manner an attracted target may remain flat, i.e. will not bow between the burls under the force of the capillary fluid.

As a specific measure, one or both of the contacting surfaces of target and table may be surface treated, or coated with a material for influencing a contacting angle between the liquid and the relevant contacting surface, in particular towards a desired clamping pressure, more in particular at operating conditions, i.e. in vacuum. In practice, given a current standard for targets in case of wafers, only the target table will be coated. So as to still influence the capillary pressure drop in the clamp according to the present invention, it is conceived to adapt the burl height to a specific, desired pressure drop, given the conditions of liquid material, target and target table contacting face material. Such adaptation may for instance be made to meet a minimum desired clamping force and to adapt to a specific combination of clamping force and distribution or mutual distance of burls, in particular to prevent local bow of the target between the burls, given a clamping pressure and resulting force on the target. A minimum burl height is hereby taken into account, while it is also considered that burl density may be adapted, for instance it may be increased to meet a minimum required clamping force. Said minimum burl height is considered in respect of a measure to accommodate dust or other contaminating particles between the burls and within the gap height. The latter of course within the constraint of a measure according to the invention of maintaining the gap height to such minimum that boiling of the fluid in between cannot occur.

Figure 8 illustrates a relevant part of a process flow for a lithographic apparatus or system improved with the present invention, where the target is formed by a wafer. The process part departs from the action and status of clean wafer table CT, indicated in the lower left corner. From there two alternative process paths may be followed. The first and above illustrated path part is characterised by first step WOT of placing a wafer on the target table, second step LIG of liquid flow into the gap between table and wafer through conduits in the table, and third step CS of sealing the conduits for water, i.e. liquid supply and air inclusion removal. The second possibility of implementing a process in accordance with the invention is indicated by the lower branch, showing the steps of first applying liquid on the table LOT, placing a wafer on the table WOT, and conduit sealing CS, which in this case merely encompasses sealing the air inclusion discharge. Such sealing is preferably performed in a central discharge or supply conduit which is linked to the table surface via multiple branches.

In a subsequent step IT the table and wafer are inserted in a part of the litho system which is to be brought to vacuum, the wafer is processed in step PW, table and wafer are removed from the apparatus in step RT, the wafer is detached from the table in step DW amongst others by removing or opening any conduit seal, and the wafer table is cleaned.

In case of liquid application LIG, water is applied by at least one, but alternatively also a multitude of water conduits through which the water is supplied to the gap. In accordance with a further aspect of this invention, filling of the gap is performed by relying on a sufficiently large capillary pressure for allowing water, or any other relevant liquid, to pull itself into the gap. In a further embodiment this process is improved, i.e. made faster by using external pressure to increase the pressure during filling. In yet a further elaboration of the invention, also the air inclusion openings are used to supply a lower pressure.

In case of water application LOT on table, application of water is performed by applying small evenly distributed droplets on the surface of the wafer table or wafer. When the wafer is placed on the wafer table the droplets will spread due to capillary action. This process can be aided by suction through opening holes. In case of sealing conduits CS, all holes that are used for filling of the gap have to be sealed after application of the liquid so as to prevent evaporation when the combination of wafer table and wafer are in vacuum. In case of detaching a wafer from the table in process step DW, the openings that are used to supply water and/or prevent air inclusions are also used to apply air pressure and, in yet a further elaboration of the invention the wafer is blown off from the table. The air pressure is in this case applied at least fairly evenly distributed so that the wafer will not brake.

It is also considered that the smaller the gap, the larger the pressure drop that is required to keep flowing speed equal. Such increase in required pressure drop is more then the pressure increase from the capillary pressure available from smaller gaps. Therefore flow by capillary pressure is slower for smaller gaps, in fact gaps beyond a critical gap height given certain conditions including liquid material and contacting face material. At very small gaps an electro-viscous effect increases the apparent viscosity of water, as may per se be known from 'capillary filling speeds of water in nano channels'.

Burls are required to reduce the influence of contamination by particles on the backside of the wafer. The maximum pitch of the burls is determined by deflection of the wafer in between the burls caused by the capillary pressure. A typical value for the pitch of the burls is 3[mm]. The height of the burl determines the gap, and is in accordance with the invention used for regulating clamping pressure given other system conditions such as materials and dimensions and vice versa. The surface per burl is made sufficient so as not to deform or brake under capillary pressure. The diameter per burl is approximately $25\mu$m or more. It is preferred that burls are shaped generally rounded, i.e. without edges, to reduce the possibility of particulate contamination during cleaning. These are particles from a tissue during wiping of the table.

In addition to or in stead of using burls 7, spacers 15 (glass grains, SiO2 grains, etc.) are dispersed uniformly over the carrying means 8 as shown in figure 9, for example by being sprayed from over the carrying means 8 or by applying a dispersed solution of the spacers 15, thus providing spacers 15. In an embodiment, the spacers 15 are dispersed in the liquid 3 which ultimately forms the layer of stationary liquid.

Apart from the concepts and all pertaining details as described in the preceding, the invention relates to all features as defined in the following set of claims. In the following set of claims, rather than fixating the meaning of a preceding term, any reference numbers corresponding to structures in the figures are for reason of support at reading the claim, included solely for indicating an exemplary meaning of a preceding term and are thus included between brackets.

## Claims

1.  Wafer table (8) for supporting a wafer (1) during processing of said wafer in a lithography system, said wafer table (8) having a top side (2) provided with burls (7) for supporting said wafer (1), wherein said burls have a height, said wafer table (8) comprising a circumferential gutter located circumferential to a wafer carrying part (2) of the wafer table, said gutter having a width larger than the height of said burls (7), wherein an outer rim of said wafer table comprises a ring (9A) arranged for leaving a vertical distance (9B) to said wafer (1) when said wafer (1) is supported by the burls (7), and wherein said wafer table (8) is adapted for inclusion of a layer of stationary liquid (3) between said wafer table (8) and said wafer (1) for clamping said wafer to said wafer table.

2. Wafer table according to claim 1, wherein said burls (7) have a height for maintaining a nominal mutual distance of between 0,1 and 10 $\mu$m between said wafer (1) and said top side (2) of said wafer table (8).

3. Wafer table according to claim 1 or claim 2, wherein said ring largely closes off a circumferential gap (9B) between said wafer table (8) and a wafer (8) supported by said burls (7).

4. Wafer table according to claim 1, 2 or 3, wherein said vertical distance (9B) is 10 to 20 times smaller than the height of said burls.

5. Wafer table according to any one of the preceding claims, wherein said wafer table (8) is provided with a plurality of circumferentially present openings (10B).

6. Wafer table according to claim 5, wherein said plurality of circumferentially present openings (10B) are included in said gutter.

7. Wafer table according to claim 1, wherein said burls (7) are dispersed uniformly over said wafer table (8).

8. Wafer table according to claim 1, wherein said wafer table (8) encompasses the presence of one or more openings that can be opened for release of fluid from said wafer table (8).

9. Wafer table according to claim 1, wherein the burls have a pitch with a maximum determined by deflection of the wafer in between the burls caused by a capillary pressure, the capillary pressure being a pressure drop over a fluid interface (4) at the edge of the layer of stationary liquid (3).

10. Lithography system comprising a wafer table according to claim 1 or claim 2.

11. Lithography system according to claim 10, further comprising dispensing means for dispensing liquid on said top side (2) of the wafer table (8).

12. Lithography system according to claim 10, further comprising a wafer (1) supported by said burls (7) of said wafer table (8), wherein a stationary layer of liquid (3) is included between said wafer table (8) and said wafer (2), said stationary layer of liquid contacting both said wafer table (8) and said wafer (1), and wherein said stationary layer of liquid (3) has a thickness which is defined by the height of said burls (7).

13. Lithography system according to claim 10, wherein said stationary layer of liquid (3) is a layer of water.

14. Lithography system according to claim 10, adapted for projecting an image or an image pattern onto said wafer (1) supported by said wafer table (8).

15. Lithography system according to claim 10, adapted for moving said wafer (1) relative to a beam source for lithography, such as a charged particle beam column of said lithography system, by means of an actuated target table or chuck, wherein said wafer table (8) is adapted for loose inclusion and without connection of conduits, in said lithography system, for treating said wafer (1) carried by the wafer table (8).

16. Lithography system according to claim 10, wherein said lithography system is a vacuum operable lithography system.

17. Lithography system according to claim 10, comprising a charged particle beam column.

**Patentansprüche**

1. Ein Wafertisch (8) zum Stützen eines Wafers (1) während der Verarbeitung des Wafers in einem Lithographiesystem, wobei der Wafertisch (8) eine Oberseite (2), die mit Noppen (7) zum Stützen des Wafers (1) versehen ist, aufweist, wobei die Noppen eine Höhe aufweisen, wobei der Wafertisch (8) eine umlaufende Rinne beinhaltet, die um einen Wafer tragenden Teil (2) des Wafertisches umlaufend angeordnet ist, wobei die Rinne eine Breite aufweist, die größer als die Höhe der Noppen (7) ist, wobei ein äußerer Rand des Wafertisches einen Ring (9A) beinhaltet, der eingerichtet ist, um einen vertikalen Abstand (9B) zu dem Wafer (1) zu lassen, wenn der Wafer (1) durch die Noppen (7) gestützt wird, und wobei der Wafertisch (8) zum Einschluss einer Schicht stationärer Flüssigkeit (3) zwischen dem Wafertisch (8) und dem Wafer (1) zum Klemmen des Wafers an den Wafertisch angepasst ist.

2. Wafertisch gemäß Anspruch 1, wobei die Noppen (7) eine Höhe zum Wahren eines nominalen gegenseitigen Abstands von zwischen 0,1 und 10 $\mu$m zwischen dem Wafer (1) und der Oberseite (2) des Wafertisches (8) aufweisen.

3. Wafertisch gemäß Anspruch 1 oder Anspruch 2, wobei der Ring eine umlaufende Lücke (9B) zwischen dem Wafertisch (8) und einem durch die Noppen (7) gestützten Wafer (8) größtenteils verschließt.

4. Wafertisch gemäß Anspruch 1, 2 oder 3, wobei der vertikale Abstand (9B) 10- bis 20-fach kleiner als die Höhe der Noppen ist.

5. Wafertisch gemäß einem der vorhergehenden Ansprüche, wobei der Wafertisch (8) mit einer Vielzahl von umlaufend vorhandenen Öffnungen (10B) versehen ist.

6. Wafertisch gemäß Anspruch 5, wobei die Vielzahl von umlaufend vorhandenen Öffnungen (10B) in der Rinne eingeschlossen ist.

7. Wafertisch gemäß Anspruch 1, wobei die Noppen (7) gleichmäßig über den Wafertisch (8) verteilt sind.

8. Wafertisch gemäß Anspruch 1, wobei der Wafertisch (8) das Vorhandensein einer oder mehrerer Öffnungen, die zum Freigeben von Fluid von dem Wafertisch (8) geöffnet werden können, umfasst.

9. Wafertisch gemäß Anspruch 1, wobei die Noppen ein Abstandsmaß mit einem Maximum aufweisen, das durch die durch einen Kapillardruck bewirkte Biegung des Wafers zwischen den Noppen bestimmt wird, wobei der Kapillardruck ein Druckabfall über eine Fluidgrenzfläche (4) an der Kante der Schicht stationärer Flüssigkeit (3) ist.

10. Ein Lithographiesystem, das einen Wafertisch gemäß Anspruch 1 oder Anspruch 2 beinhaltet.

11. Lithographiesystem gemäß Anspruch 10, das ferner ein Ausgabemittel zum Ausgeben von Flüssigkeit auf der Oberseite (2) des Wafertisches (8) beinhaltet.

12. Lithographiesystem gemäß Anspruch 10, das ferner einen durch die Noppen (7) des Wafertisches (8) gestützten Wafer (1) beinhaltet, wobei eine stationäre Schicht Flüssigkeit (3) zwischen dem Wafertisch (8) und dem Wafer (2) eingeschlossen ist, wobei die stationäre Schicht Flüssigkeit sowohl den Wafertisch (8) als auch den Wafer (1) berührt und wobei die stationäre Schicht Flüssigkeit (3) eine Dicke aufweist, die durch die Höhe der Noppen (7) definiert ist.

13. Lithographiesystem gemäß Anspruch 10, wobei die stationäre Schicht Flüssigkeit (3) eine Schicht Wasser ist.

14. Lithographiesystem gemäß Anspruch 10, das zum Projizieren eines Bildes oder eines Bildmusters auf den durch den Wafertisch (8) gestützten Wafer (1) angepasst ist.

15. Lithographiesystem gemäß Anspruch 10, das zum Bewegen des Wafers (1) relativ zu einer Strahlquelle für Lithographie, wie etwa eine Ladungsträgerstrahlsäule des Lithographiesystems, mittels eines betätigten Zieltisches oder einer betätigten Zielspannvorrichtung angepasst ist, wobei der Wafertisch (8) zum losen Einschluss und ohne Verbindung von Leitungen in dem Lithographiesystem zur Behandlung des durch den Wafertisch (8) getragenen Wafers (1) angepasst ist.

16. Lithographiesystem gemäß Anspruch 10, wobei das Lithographiesystem ein zum Vakuumbetrieb fähiges Lithographiesystem ist.

17. Lithographiesystem gemäß Anspruch 10, das eine Ladungsträgerstrahlsäule beinhaltet.

**EP 2 660 655 B1**

**Revendications**

1. Table porte-tranche (8) pour supporter une tranche (1) au cours du traitement de ladite tranche dans un système de lithographie, ladite table porte-tranche (8) présentant un côté supérieur (2) pourvu de nœuds (7) pour supporter ladite tranche (1), où lesdits nœuds ont une hauteur, ladite table porte-tranche (8) comprenant une gouttière circonférentielle placée circonférentiellement à une partie porteuse de tranche (2) de la table porte-tranche, ladite gouttière présentant une largeur plus grande que la hauteur desdits nœuds (7), où un rebord externe de ladite table porte-tranche comprend un anneau (9A) agencé pour laisser une distance verticale (9B) jusqu'à ladite tranche (1) lorsque ladite tranche (1) est supportée par les nœuds (7), et où ladite table porte-tranche (8) est conçue pour l'inclusion d'une couche de liquide stationnaire (3) entre ladite table porte-tranche (8) et ladite tranche (1) pour abloquer ladite tranche sur ladite table porte-tranche.

2. Table porte-tranche selon la revendication 1, où lesdits nœuds (7) ont une hauteur pour maintenir une distance mutuelle nominale comprise entre 0,1 et 10 $\mu$m entre ladite tranche (1) et ledit côté supérieur (2) de ladite table porte-tranche (8).

3. Table porte-tranche selon la revendication 1 ou la revendication 2, où ledit anneau condamne en grande partie un écartement circonférentiel (9B) entre ladite table porte-tranche (8) et une tranche (8) supportée par lesdits nœuds (7).

4. Table porte-tranche selon la revendication 1, la revendication 2 ou la revendication 3, où ladite distance verticale (9B) est 10 à 20 fois plus petite que la hauteur desdits nœuds.

5. Table porte-tranche selon n'importe laquelle des revendications précédentes, où ladite table porte-tranche (8) est pourvue d'une pluralité d'ouvertures présentes circonférentiellement (10B).

6. Table porte-tranche selon la revendication 5, où ladite pluralité d'ouvertures présentes circonférentiellement (10B) sont incluses dans ladite gouttière.

7. Table porte-tranche selon la revendication 1, où lesdits nœuds (7) sont dispersés uniformément par-dessus ladite table porte-tranche (8).

8. Table porte-tranche selon la revendication 1, où ladite table porte-tranche (8) renferme la présence d'une ou de plusieurs ouvertures qui peuvent être ouvertes pour libérer du fluide de ladite table porte-tranche (8).

9. Table porte-tranche selon la revendication 1, où les nœuds ont un pas avec un maximum déterminé par un fléchissement de la tranche entre les nœuds causé par une pression capillaire, la pression capillaire étant une chute de pression par-dessus une interface de fluide (4) au niveau du bord de la couche de liquide stationnaire (3).

10. Système de lithographie comprenant une table porte-tranche selon la revendication 1 ou la revendication 2.

11. Système de lithographie selon la revendication 10, comprenant en sus un moyen de distribution pour distribuer du liquide sur ledit côté supérieur (2) de la table porte-tranche (8).

12. Système de lithographie selon la revendication 10, comprenant en sus une tranche (1) supportée par lesdits nœuds (7) de ladite table porte-tranche (8), où une couche de liquide stationnaire (3) est incluse entre ladite table porte-tranche (8) et ladite tranche (2), ladite couche de liquide stationnaire étant au contact à la fois de ladite table porte-tranche (8) et de ladite tranche (1), et où ladite couche de liquide stationnaire (3) a une épaisseur qui est définie par la hauteur desdits nœuds (7).

13. Système de lithographie selon la revendication 10, où ladite couche de liquide stationnaire (3) est une couche d'eau.

14. Système de lithographie selon la revendication 10, conçu pour projeter une image ou un motif d'image sur ladite tranche (1) supportée par ladite table porte-tranche (8).

15. Système de lithographie selon la revendication 10, conçu pour déplacer ladite tranche (1) relativement à une source de faisceau pour lithographie, telle qu'une colonne à faisceau de particules chargées dudit système de lithographie, au moyen d'une table, ou plateau de maintien, porte-cible actionnée, où ladite table porte-tranche (8) est conçue pour l'inclusion libre et sans raccordement de conduits, dans ledit système de lithographie, pour traiter ladite tranche (1) portée par la table porte-tranche (8).

**16.** Système de lithographie selon la revendication 10, où ledit système de lithographie est un système de lithographie apte au fonctionnement sous vide.

**17.** Système de lithographie selon la revendication 10, comprenant une colonne à faisceau de particules chargées.

**FIG. 1**

**FIG. 2**

**FIG. 3**

FIG. 4

FIG. 5

FIG. 6

FIG. 7

FIG. 8

FIG. 9

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004038509 A
- EP 0100648 A
- JP 7237066 B
- JP 8064662 B
- WO 0221579 A
- US 20050186517 A
- EP 511928 A
- US 20050122503 A
- JP 2006310588 B
- EP 1304727 A

**Non-patent literature cited in the description**

- The Physics of negative pressure. Discover, 27 March 2003